# EUROPEAN PATENT SPECIFICATION

(11) **EP 0 320 748 B1**
(45) Date of publication and mention of the grant of the patent: **17.02.1993**
(21) Application number: 88120320.2
(22) Date of filing: 06.12.1988
(51) Int. Cl.: H03L 7/14

(54) **Self adjusting phase lock circuit**
Selbstregelnde Phasenregelschaltung
Circuit d'asservissement de phase à autoréglage

(30) Priority: 18.12.1987 IT 2307887
(43) Date of publication of application: 21.06.1989
(73) Proprietor: BULL HN INFORMATION SYSTEMS ITALIA S.p.A., 10014 Caluso (Torino) (IT)
(72) Inventor: Vitiello, Paolo, I-20017 RHO (MI) (IT); Bergamo, Luca, I-20146 Milano (IT)

(56) References cited:
- EP-A- 0 164 806
- US-A- 4 246 545
- US-A- 4 703 520
- PATENT ABSTRACTS OF JAPAN, vol. 1, no. 126 (E-77)[5497], 20th October 1977, page 5497 E 77 & JP-A-52 60 052
- PATENT ABSTRACTS OF JAPAN, vol. 9, no. 49 (E-300)[1772], 2nd March 1985 & JP-A-59 190 725

## Description

The present invention relates to a self adjusting phase lock circuit.

In order to recognize digital information read out from a magnetic media, typically a magnetic disk, phase lock circuits are used.

When a magnetic media is read, it produces, through suitable reading circuits, a sequence of electrical pulses having a variable frequency modulated around a nominal frequency.

Modulation has two components: a logical or meaningfull modulation and a noise modulation caused by changes of the magnetic media speed as to a nominal speed.

In order to recognize the read out data it is required to discriminate between logical component and noise.

This is obtained by phase lock circuits which basically comprise:
- a phase comparator and discriminator, which receives as input the electrical read out pulses and a periodical signal having frequency locked to the basic actual frequency of the read out pulses.
   The phase comparator and discriminator outputs a logic data signal and one or more phase error signals.
- an integrating network, receiving as input the phase error signals, and outputing a variable voltage signal, related to the error between the average frequency of the read out pulses and the frequency of the periodic reference signal.
- a voltage controlled oscillator (VCO) which outputs a signal at a frequency variable as a function of the variable voltage received at a control input.

The phase comparator, phase discriminator, the integrating network and the voltage controlled oscillator form a feedback frequency control system for the oscillator, where the control voltage for the oscillator consists in the voltage output by the integrating network and the controlled variable is the variable frequency signal output by the oscillator and input to the phase comparator/discriminator.
Since the digital information read out from a magnetic media consists in a plurality of intermittent bit streams, means are further provided to impose a self run condition to the phase lock circuit when the bit stream is missing.

In the self run condition, the voltage controlled oscillator is caused to generate an output signal having a frequency close to a predetermined reference frequency.

For instance, the document JP-A-5260052 discloses the addition to the basic components of the phase lock circuit of a reference frequency generator, a frequency comparator for comparing the frequency of the signal generated by the voltage controlled oscillator with the frequency of the signal generated by the reference frequency generator, a first switch for controlling the inputing of an error signal generated by the frequency comparator to the input of the integrating network and a sample and hold circuit, coupled by a second switch to the output of the integrating network, for periodically storing the control voltage in output from the integrating network, which causes, when applied to the input of the voltage controlled oscillator, the VCO running at the reference frequency.
The sample and hold circuit then "adds" this signal to the control error signal generated under normal operative conditions in which the bit stream is present.

Both phase comparators as well as voltage controlled oscilllators are available on the market in form of integrated circuits, for instance of the types manufactured by the firm Signetics, with code SCB58459 and by the firm Texas Instruments with Code SN74LS629 respectively.

The voltage controlled oscillator is a critical element of this control system.

Its parametrical characteristics "input voltage/output frequency", are largely variable from product unit to product unit, and are further affected by temperature as well as by a range voltage VRANGE input to an adjustmement input.

VRANGE defines by its value the proportionality coefficient which relates the control voltage to the output frequency.

To provide for a correct and reliable operation of the control system it is required to define a predetermined nominal working point for the oscillator.

In other words, independently of the used item, a predetermined output frequency must correspond to a predetermined input control voltage, centered in the admissible control voltage range. Further the set point must not drift with temperature changes.

This is obtained by means of suitable adjusting circuits, comprising trimming resistors and positive temperature coefficient thermistors (PCT) which provide at the adjusting input a range voltage VRANGE suitable for ech particular unit and variable with the temperature so as to compensate for spread and drift in the operation of the used component.

The adjusting operation inherent with the use of trimmers, negatively affects the manufacturing cost of the phase lock circuits. Further it compensates only in part for thermal drift.

These limitations are overcome by the self adjusting phase lock circuit of the present invention in which it is the control circuit itself which periodically provides to generate and adjust the range voltage as a function of the actual response of the used component.

The invention consists in providing circuit elements which enable the phase lock circuit to operate in self adjusting mode.

When the phase lock circuit is in self adjusting mode, a predetermined voltage, corresponding to the desired set point is input to the control input of the oscillator and the output frequency is compared with a reference frequency, corresponding to a desired output frequency.

An error signal is generated which modifies the range voltage VRANGE input to the oscillator.

This operative mode may be periodically imposed at fixed time periods, or when the phase lock circuit is idle, in particular, for phase lock circuits working in magnetic disk units, when the reading head is moving from one track to another.
Differing from the self running circuits such as the one disclosed by JP-A-5260052, the purpose of the invention is to set the operation of the voltage controlled oscillator for optimal performances.
This is obtained by applying to the control input of the VCO a predetermined voltage and by correcting the range voltage VRANGE so that the VCO runs at the reference frequency.
The circuits used to obtain this result are similar, at some extent, to the circuits disclosed by document JP-A-5260052, but the purpose and the arrangement of the several elements are entirely different.

The features of the invention will appear more clearly from the following description and from the enclosed drawings where:
- Figure 1 shows in block diagram a phase lock circuit of the prior art
- Figure 2 and 3 show in block diagram the self adjusting phase lock circuit of the invention operating in normal mode (Figure 2) and in self adjusting mode (Figure 3) respectively.
- Figure 4 shows a preferred embodiment of the self adjusting phase lock circuit of the invention.

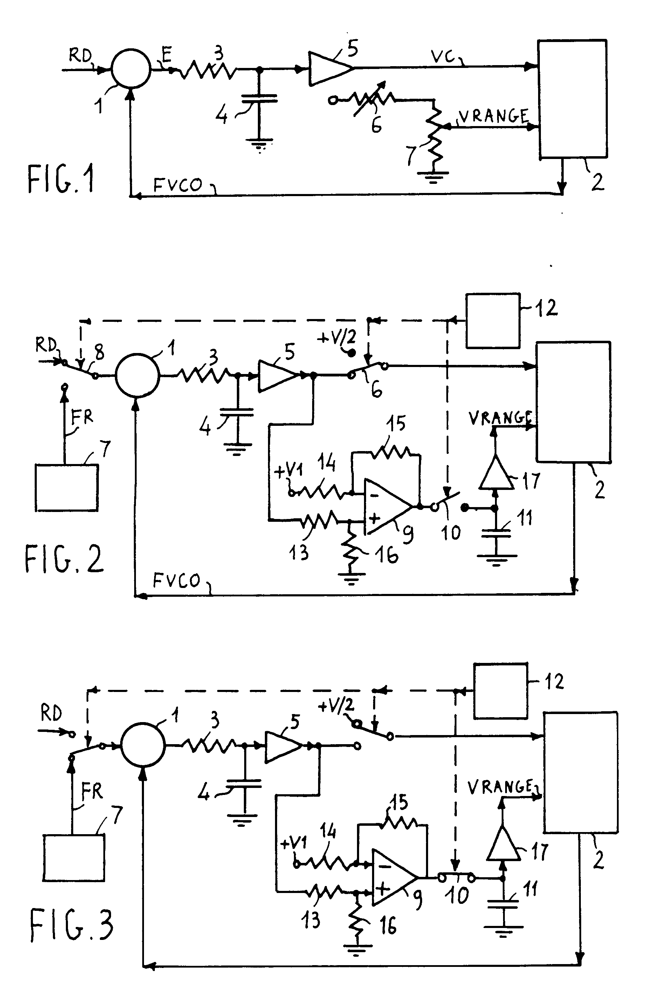

Figure 1 shows in block diagram a phase lock circuit of the prior art.

The circuit comprises a frequency comparator 1, a voltage controlled oscillator 2, an integrating network consisting in resistor 3 and capacitor 4, an operational amplifier 5 having unit gain, a thermistor 6 and a voltage divider 7.

Comparator 1 receives as inputs a RD signal, frequency modulated, consisting in a sequence of electrical pulses read out from a magnetic media, and a FVCO square wave signal, having variable frequency which is the output from oscillator 2.

Although comparator 1 may be implemented in several ways, including analogic circuits, digital comparators are preferably used because of their intrinsic precision and stability.

The output of comparator 1 is an error signal E consisting in electrical pulses having alternatively a level +V (the Voltage supply of Comparator 1) or level 0 and duration variable as a function of the frequency error of the RD signal as to the FVCO signal in input.

When the two frequencies coincide, the output pulses at level +V have the same width of the output pulses at level 0. If the RD signal frequency is greater than the FVCO signal frequency, the pulses at level +V have a width greater than the one of the pulses at level 0 and viceversa if the RD signal frequency is lesser than the FVCO signal frequency.

Some comparators produce at the output (or at two distinct outputs) pulses at level +V or at level 0 in mutual exclusive way, depending on the frequency of signal RD being greater or lesser than FVCO.

The effect of the error pulses input to the integrating network is to load capacitor 4 at a variable voltage level.

For instance if RD and FVCO have the same frequency and the error pulses, alternatively at level +V and 0 have the same width, the charge voltage of capacitor 4 is + V/2.

If RD has a frequency greater than VFCO, the charge voltage will be greater than +V/2 and lesser if RD has a frequency lesser than FVCO.

Voltage +V/2 is the normal working point of the control system. It defines the operative conditions of the system when there is no error.

The charge voltage of capacitor 4, referenced as VC, is input to the control input of voltage controlled oscillator 2, through operational amplifier 5, having unit gain. The function of operational amplifier 5 is only to decouple capacitor 4 from the input impedance of oscillator 2, which input is relatively low.

In fact an operational amplifier has a virtually infinite input impedance. As a consequence it does not drain current from capacitor 4 and does not alter the electrical status of the integrating network.

The controlled oscillator 2 has characteristics which at first approximation are defined by equation:

$\text{FVCO = VC·K1/(VRANGE-K2)}$

where:
- FVCO: is the output frequency of the oscillator
- FV: is the input control voltage, that is the charge voltage of capacitor 4.
- K1,K2: are parametric coefficients.
- VRANGE: is an adjusting voltage input to an adjusting input.

Voltage VRANGE is preferably obtained from a voltage divider 7 and a PCT 6, series connected between voltage source +V and ground.

The center tap of voltage divider 7 is connected to the adjusting input of oscillator 2. The adjusting input may therefore receive a voltage comprised between 0V and a voltage close to +V.

Should K1 be an invariant characteristic of oscillator 2, no adjusting problem would arise and it would be possible to define a fixed voltage VRANGE which corresponds to a predetermined VC equal to +V/2 and to an output frequencyFVCO equal to the nominal value of the input frequency of RD signal.

Unfortunately, K1 is variable from unit component to unit component and further with temperature.

An adjusting operation is therefore required, in the manufacturing or maintenance of the described circuits, which implies, at a predetermined temperature, the inputing of a known reference frequency FR as a substitute for RD, such frequency corresponding to the nominal frequency of RD, and to adjust the position of the voltage divider 7 cursor, until the frequency of signal FVCO equals the reference one.

This adjustment, intrinsically provides to obtain VC=V/2.

If not a permanent offset of FVCO from FR would result.

The adjusting operation compensates for performance spreads of the oscillator components and assures a correct working point to the control system at the moment and in the adjustment environment. It does not assures that the set point is maintained with time and at differing temperatures. The use of a PCT thermistor compensates only in part for thermal drift.

These considerations will make easier the understanding of the self adjusting phase lock circuit which is the object of the present invention and whose block diagram is shown in figures 2 and 3.

Figures 2 and 3 show the same circuit in normal operating mode and in self adjusting mode respectively.

The components common to the circuit of Fig. 1 and to the circuit of figures 2,3 are indicated with the same reference numeral.

The circuit of figure 2 comprises, in addition to frequency comparator 1, oscillator 2, resistor 3 capacitor 4, amplifier 5, already seen in figure 1 and connected together the same way, an electronic switch (multiplexer) 6, an oscillator 7 for the generation of a reference frequency VR, a second electronic switch 8, a second operational amplifier 9, having function of a subtractor with gain, an electronic switch 10, a capacitor 11 and a third operational amplifier 17, used as a decoupling element with unit gain.

A disk unit controller 12 provides a control signal which in normal operating read mode maintains the switches in the position shown in figure 2 and in operative adjustment mode maintains the switches in the position shown in figure 3.

Referring to figure 2 it can be seen that comparator 1 receives as input, through switch 8, signal RD and that capacitor 4 charge voltage VC is input, through amplifier 5 and switch 6, to the control input of oscillator 2. Voltage VC is further input to the non inverting input of amplifier 9, through a resistor 13. The inverting input of amplifier 9 is connected to a reference voltage V1, through a resistor 14.

For operation of the amplifier as a subtractor with gain a resistor 15 connects the inverting input to the output.

The non inverting input is ground connected through resistor 16.

The output of amplifier 9 is, in figure 2, isolated, owing to switch 10 being open, whilst in figure 3 is closed, through switch 10, on capacitor 11 and on input of amplifier 17, whose output is connected to the adjusting input of oscillator 2.

In the normal operative mode of figure 2 the phase lock circuit operates in the same way of the circuit of figure 1, the only difference being that the voltage VRANGE in input to the oscillator is the charge voltage of capacitor 11.

Figure 3 shows how voltage VRANGE is obtained in the self adjusting operation mode.

In this operative mode switch 6 connects the control input of oscillator 2 to a fixed voltage source +V/2 corresponding to the nominal working point or set point, and switch 8 connects the input of comparator 1 to the output of oscillator 7.

Therefore the integrating network produces a signal VC related to the frequency error between FR and FVCO. Signal VC is input to amplifier 9 which outputs to capacitor 11 and to the adjusting input of oscillator 2 (through switch 10 which is closed) a voltage VRANGE obtained according to the following transfer function.

$\text{VRANGE = (V1-VC)·K3}$

where K3 is a gain coefficient defined by the ratio between the value of feedback and biasing resistors of amplifier 9.

Values for K3 and V1 may be suitably choosen in relation to the voltage supply for components 1,2 and the admissible voltage range for VRANGE.

For integrated circuits powered from a +5V source and with an admissible voltage range for VRANGE comprised between 0V and +5V, a suitable choice is V1 = +3V and K3=5.

In this way, for a drift of VC around the working point +V/2=2,5 V comprised between 2 and 3 Volt, VRANGE spans from +5V to 0V.

The control loop so formed provides to load capacitor 11 and to input to the adjusting input of oscillator 2 a voltage VRANGE which establishes a stable state in which the offset of VC from the set point is minimum as well as the offset of FVCO from the reference frequency FR.

When switching from the adjusting mode to the normal operating mode, the opening of switch 10 does not change the charge status of capacitor 11 and the voltage VRANGE, previously input to oscillator 2, is maintained.

By suitably selecting capacity of capacitor 11, in the order of 100 nf, the charge level is maintained substantially unchanged for periods in the order of hundreds of msec. This is because the input impedance of amplifer 17 is virtually infinite.

It is clear that a circuit like the described one provides a self adjustment which is periodically renewed every time it is switched from normal operating mode to adjustment mode.

Therefore, if in the time course thermal drift of components occurs or anyhow a change in the component response, the circuit automatically provides to change voltage VRANGE so as to establish a working point which differs from the nominal point for a minimal amount.

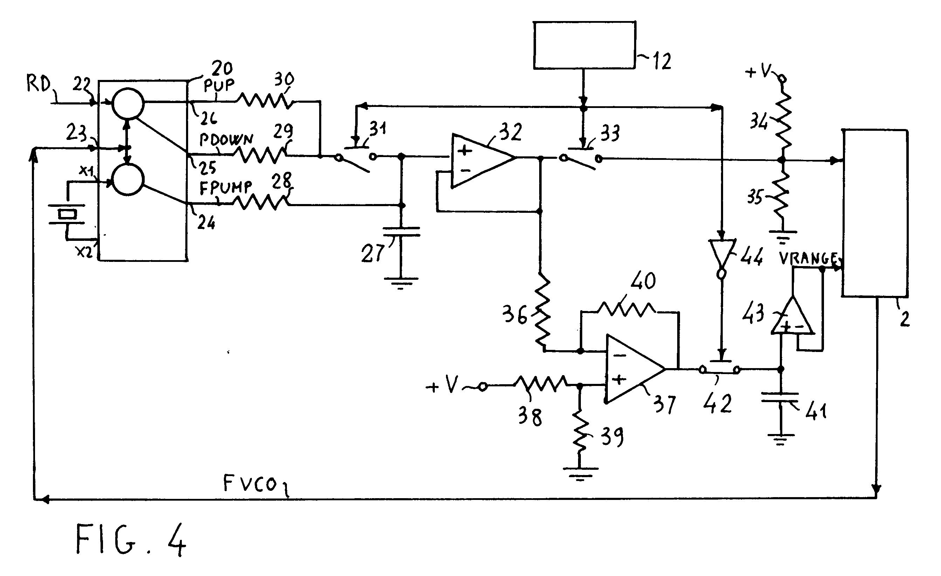

Having described in conceptual and schematic terms a self adjusting phase lock circuit in accordance with the invention, a preferred form of embodiment is now described with reference to Figure 4.

The preferred embodiment makes use of circuit components easily available on the market and provides some circuital simplification.

The related description is further useful to point out some of the several constructive changes which can be made.

In figure 4 the phase lock circuit comprises a comparator/ discriminator 20, consisting in an integrated circuit SCB68459 and a controlled oscillator 2 consisting in integrated circuit 74LS629, already mentioned.

Comparator 20 has two inputs X1,X2 for connection to an external oscillator 21, which produces a reference signal FR having a frequency twice the nominal working frequency, that is the nominal frequency of read signal RD.

Comparator 20 receives signal RD at one input 22 and signal FVCO at an input 23.

Circuit 20 comprises "de facto" two distinct comparators:
- a first frequency comparator, which compares the frequency of signal FR with the frequency of signal FVCO (and for this reason the voltage controlled oscillator 2 is set to operate at a frequency twice the nominal working frequency of signal RD) and outputs at output 24 a signal FPUMP which periodically and alternatively rises to +5V for the period width of signal FR and drops to 0V for the period width of signal FVCO;
- a second phase comparator which compares the phase of signal RD with the phase of signal FVCO and outputs a periodical signal PUP having level +5V and width equal to the phase lag of RD as to FVCO on output 26, and a periodical signal PDOWN having level 0V and fixed width equal to the half period of FVCO on output 25, if RD leads as to FVCO.

In other words, as already mentioned, a plurality of error pulse signals is generated on distinct outputs.

Output 24 is connected to a first armature of a capacitor 27, through a resistor 28.

The second armature of capacitor 27 is grounded.

Output 25 is connected to the first armature of capacitor 27 through a resistor 29, series connected with an electronic switch 31.

Output 26 is connected to the first armature of capacitor 27 through a resistor 30, series connected with the electronic switch 31.

Resistors 28,29,30 and capacitor 27 form an integrating network in which signal PUP tends to charge capacitor 27, signal PDOWN tends to discharge capacitor 27 and signal FPUMP tends to charge or discharge capacitor 27 depending on FVCO having a frequency lesser or greater that FR.

When switch 31 is closed, capacitor 27 is charged at a voltage level related to the phase error of RD as to FVCO and corrected as a function of the frequency error of FVCO as to FR.

When switch 31 is open, capacitor 27 is powered by FPUMP signal only and is charged at a voltage level related to the frequency error of FVCO as to FR.

The first armature of capacitor 27 is connected to the non inverting input of operational amplifier 32, operating as a voltage follower with high input impedance, hence as a simple decoupler.

The output of amplifier 32 is connected to the control input of oscillator 2, through an electronic switch 33.

The control input of oscillator 2 is further connected to voltage source +V = 5V through a resistor 34 of relatively high value (51 KOhm) and to ground, through a resistor 35 having the same value of resistor 34.

When switch 33 is closed, the control voltage input to oscillator 2 is substantially the charge voltage VC of capacitor 27, because the output impedance of amplifier 32, added to the internal resistance of analogic switch 33 is in the order of 100 Ohm, and much lower than the value of resistors 34,35.

When the switch 33 is open, with a virtually infinite resistance (10 MOhm), the control input of oscillator 2 is biased with a fixed reference voltage equal to +V/2=2,5V.

The output of amplifier 32 is connected to the inverting input of operational amplifier 37, through a resistor 36.

The non-inverting input of amplifier 37 is connected to the voltage source +V, through a resistor 38, and to ground, through a resistor 39.

A feedback resistor 40 connects the output to the non inverting input.

For a value of resistors 36,38 equal to 56 KOhm and a value of resistors 40,39 equal to 100 KOhm the transfer function of the amplifier is:

$\text{VOUT=(+V-VC)·100/56}$

with a gain slighty lesser than 2.

Therefore for a change in VC comprised between 2,46V and 5V VOUT spans form 0 to 5 V.

The output of operational amplifier 37 is connected to the first armature of a capacitor 41, through an electronic switch 42.

The second armature of capacitor 41 is grounded.

The first armature is further connected, through an operational amplifier 43 having unit gain, to the adjusting input of controlled oscillator 2.

Electronic switches 31,32,42 are for instance analogic switches marketed by the firm National with code MM74HC4066, whilst the operational amplifiers may be those marketed by firm NATIONAL with code LF347.

A disk control unit 43 provides control signal CTR to switches 31,33.

When CTR = 5V (nominal) the switches are closed and when CTR=OV (nominal) the switches are open.

CTR is also input, through inverter 44, to the control input of switch 42.

It is clear that the operation of the circuit shown in figure 4, is quite similar to the one of the circuit shown in figures 2,3, even if there is some difference in the circuit embodiment, such as the use of electronic switches instead of toggle switches, the direct use of the powering voltage as operand for the operational amplifier 37, the permanent connection of the control input of oscillator 2 to a reference voltage VR (Overriden by voltage VC when switch 33 is closed) and the use of two distinct comparators (in the integrated circuit 20) for comparing RD with FVCO and FR with FVCO.

## Claims

1. Self adjusting phase lock circuit, of the type comprising first means (1,3,4,5) for comparing the frequency and/or phase of a reference signal (FVCO) with a periodical input signal (RD) having variable frequency and for generating a control voltage (VC) related to the frequency/phase error between the reference signal (FVCO) and the input signal (RD) and further comprising
- a voltage controlled oscillator (2) receiving said control voltage VC at a control input, an adjusting voltage (VRANGE) at an adjusting input and outputting said reference signal (FVCO) as a function of said control voltage (VC) and said adjusting voltage (VRANGE),
- second means (8,1,3,4,5) for comparing the frequency of said reference signal (FVCO) with a nominal working frequency (FR) and for generating a voltage related to the error between said nominal working frequency (FR) and the frequency of said reference signal (FVCO),
said phase lock circuit being characterized by comprising:
- third means (6) for decoupling said control voltage (VC) from said control input and for applying to said control input a predetermined reference voltage,
- fourth means (9,14,15,16), operational on the voltage generated by said second means (8,1,3,4,5), for generating said adjusting voltage (VRANGE),
- fifth means (10,11) for sampling and holding said adjusting voltage (VRANGE),
- sixth high input impedance means (17) for applying said adjusting voltage (VRANGE) sampled and hold by said fifth means (10,11)to said adjusting input,
- seventh means (12) for synchronously controlling said third (6) and fifth means (10,11) to respectively decouple and sample,
- said second, fourth, fifth, sixt means and said oscillator forming a feedback control loop of the frequency of said reference signal (FVCO) wherein said adjusting voltage (VRANGE) is the error control signal.

2. Phase lock circuit as claimed in claim 1, wherein said second means (8,1,3,4,5) comprises said first means (1,3,4,5) and further means (8) for substituting said nominal working frequency (FR) to said periodical input signal (RD) having variable frequency, as input to said first means.

3. Phase lock circuit as claimed in claim 1, wherein said first means (1,3,4,5) comprises A) a phase comparator (20) for comparing the phase of said reference signal (FVCO) with the phase of said periodical input signal (RD) and for generating at least a first phase error signal (PUP), a frequency comparator (20) for comparing the frequency of said nominal working frequency (FR) with the frequency of said reference signal (FVCO) and for generating a frequency error signal (FPUMP), and B) an integrating network (28,30,27) of said first phase error and said frequency error for generating an error voltage (VC) related to said phase and frequency errors, and wherein
- said third means (6) comprises a first analog switch (33) and a voltage divider (34,35) connected to the output of said first switch (33),
- said second means comprises said frequency comparator (20), said integrating network (28,30,27) and a second analog switch (31) for decoupling said first phase error signal from input to said integrating network,
- said fourth means comprises a first operational amplifier (37) performing a subtractive gain operation of the voltage generated by said third means from a reference voltage, and
- said fifth means comprises a third analog switch (42) connected to the output of said first operational amplifier (37) and a capacitor (41) connected between the output of said third switch and ground.

## Patentansprüche

1. Selbststeuernde Phasenverriegelungsschaltung mit einer ersten Einrichtung (1, 3, 4, 5) zum Vergleich der Frequenz und/oder Phase eines Bezugssignals (FVCO) mit einem periodischen Eingangssignal (RD) veränderbarer Frequenz und zum Erzeugen einer Steuerspannung (VC) in Abhängigkeit vom Frequenz/Phasen-Fehler zwischen dem Bezugssignal (FVCO) und dem Eingangssignal (RD) sowie ferner mit
- einem spannungsgesteuerten Oszillator (12), der die Steuerspannung (VC) an einem Steuereingang sowie eine Einstellspannung (VRANGE) an einem Einstelleingang empfängt und als Ausgangssignal das Bezugssignal (VFCO) als Funktion der Steuerspannung (VC) und der Einstellspannung (VRANGE) liefert,
- einer zweiten Einrichtung (8, 1, 3, 4, 5) zum Vergleich der Frequenz des Bezugssignals (VFCO) mit einer Nenn-Arbeitsfrequenz (FR) und zum Erzeugen einer Spannung in Abhängigkeit von der Abweichung zwischen der Nenn-Arbeitsfrequenz (FR) und der Frequenz des Bezugssignals (FVCO),
wobei die Phasenverriegelungsschaltung **gekennzeichnet** ist **durch:**
- eine dritte Einrichtung (6) zum Wegnehmen der Steuerspannung (VC) vom Steuereingang und zum Anlegen einer vorgegebenen Bezugsspannung an diesen Steuereingang;
- eine vierte Einrichtung (9, 14, 15, 16) betrieben aus der von der zweiten Einrichtung (8, 1, 3, 4, 5) erzeugten Spannung zum Erzeugen der Einstellspannung (VRANGE);
- eine fünfte Einrichtung (10, 11) zum Abtasten und Speichern der Einstellspannung (VRANGE);
- eine sechste Einrichtung (17) hoher Eingangsimpedanz zum Anlegen der durch die fünfte Einrichtung (10, 11) abgetasteten und gespeicherten Einstellspannung (VRANGE) an den Einstelleingang;
- eine siebente Einrichtung (12) zur synchronen Steuerung der dritten (6) und fünften (10, 11) Einrichtung zum Entkoppeln bzw. Abtasten;
- wobei die zweite, vierte, fünfte und sechste Einrichtung und der Oszillator einen Rückkopplungssteuerkreis für die Frequenz des Bezugssignals (FVCO) bilden und die Einstellspannung (VRANGE) das Fehlersteuersignal ist.

2. Phasenverriegelungsschaltung nach Anspruch 1, bei der die zweite Einrichtung (8, 1, 3, 4, 5) die erste Einrichtung (1, 3, 4, 5) umfaßt und ferner Mittel (8) enthält, um als Eingangssignal für die erste Einrichtung die Nenn-Arbeitsfrequenz (FR) durch das Periodische Eingangssignal (RD) zu ersetzen.

3. Phasenverriegelungsschaltung nach Anspruch 1, bei der die erste Einrichtung (1, 3, 4, 5) umfaßt:
A) eine Phasenvergleichsschaltung (20) zum Vergleichen der Phase des Bezugssignals (FVCO) mit der Phase des periodischen Eingangssignals (RD) und zum Erzeugen wenigstens eines ersten Phasenfehlersignals (PUP), einen Frequenzvergleicher (20) zum Vergleichen der Frequenz der Nenn-Arbeitsfreuqenz (FR) mit der Frequenz des Bezugssignals (FVCO) und zum Erzeugen eines Frequenzfehlersignals (FPUMP); und
B) ein Integrationsnetzwerk (28, 30, 27) für das erste Phasenfehlersignal und das Frequenzfehlersignal zwecks Erzeugung einer Fehlerspannung (VC) in Abhängigkeit von diesen Phasen und Frequenzfehler; und
wobei
- die dritte Einrichtung (6) einen ersten Analogschalter (33) sowie einen an den Ausgang des ersten Schalters (33) angeschlossenen Spannungsteiler (34, 35) umfaßt;
- die zweite Einrichtung den Frequenzvergleicher (20), das Integrationsnetzwerk (28, 30, 27) sowie einen zweiten Analogschalter (31) enthält zum Wegnehmen des ersten Phasenfehlersignals vom Eingang des Integrationsnetzwerks;
- die vierte Einrichtung einen ersten Operationsverstärker (37) aufweist, der durch Subtraktion mit Verstärkung die von der dritten Einrichtung erzeugte Spannung von einer Bezugsspannung subtrahiert; und
- die fünfte Einrichtung einen an den Ausgang des ersten Operationsverstärkers (37) angeschlossenen dritten Analogschalter (42) sowie einen Kondensator (41) umfaßt, der zwischen den Ausgang des dritten Schalters und Masse eingeschaltet ist.

## Revendications

1. Circuit à asservissement de phase à auto-réglage, du type comportant des premiers moyens (1,3,4,5) pour comparer la fréquence et/ou la phase d'un signal de référence (FVCO) avec un signal entré périodiquement, (RD), de fréquence variable et pour générer une tension de commande (VC) fonction de l'erreur de fréquence/de phase entre le signal de référence (FVCO) et le signal entré (RD), et comportant en outre
- un oscillateur commandé en tension (2) recevant ladite tension de commande VC à une entrée de commande, une tension de réglage (VRANGE) à une entrée de réglage et fournissant ledit signal de référence (FVCO) en fonction de ladite tension de commande (VC) et de ladite tension de réglage (VRANGE),
- des seconds moyens (8,1,3,4,5) pour comparer la fréquence dudit signal de référence (FVCO) avec une fréquence de travail nominale (FR) et pour générer une tension fonction de l'erreur entre ladite fréquence de travail nominale (FR) et la fréquence dudit signal de référence (FVCO),
ledit circuit à asservissement de phase étant caractérisé par le fait qu'il comporte:
- des troisièmes moyens (6) pour découpler ladite tension de commande (VC) d'avec ladite entrée de commande et pour appliquer à ladite entrée de commande une tension de référence prédéterminée,
- des quatrièmes moyens (9,14,15,16), opérant sur la tension générée par lesdits seconds moyens (8,1,3,4,5), pour générer ladite tension de réglage (VRANGE),
- des cinquièmes moyens (10,11) pour échantillonner et mémoriser ladite tension de réglage (VRANGE),
- des sixièmes moyens (17) à haute impédance d'entrée pour appliquer à ladite entrée de réglage ladite tension de réglage (VRANGE) échantillonnée et mémorisée par lesdits cinquièmes moyens (10,11),
- des septièmes moyens (12) pour commander en synchronisme lesdits troisièmes (6) et lesdits cinquièmes (10,11) moyens pour respectivement découpler et échantillonner,
lesdits seconds, quatrièmes, cinquièmes, sixièmes moyens et ledit oscillateur formant une boucle de commande de rétroaction de la fréquence dudit signal de référence (FVCO), boucle dans laquelle ladite tension de réglage (VRANGE) constitue le signal de contrôle d'erreur.

2. Circuit à asservissement de phase comme revendiqué dans la revendication 1, dans lequel lesdits seconds moyens (8,1,3,4,5) comportent lesdits premiers moyens (1,3,4,5) et de plus des moyens (8) pour substituer ladite fréquence de travail nominale (FR) audit signal entré périodiquement (RD) de fréquence variable, au titre de signal d'entrée desdits premiers moyens.

3. Circuit à asservissement de phase comme revendiqué dans la revendication 1, dans lequel lesdits premiers moyens (1,3,4,5) comportent A) un comparateur de phase (20) pour comparer la phase dudit signal de référence (FVCO) avec la phase dudit signal entré périodiquement (RD) et pour générer au moins un premier signal d'erreur de phase (PUP), un comparateur de fréquence (20) pour comparer la fréquence de ladite fréquence de travail nominale (FR) avec la fréquence dudit signal de référence (FVCO) et pour générer un signal d'erreur de fréquence (FPUMP), et B) un réseau intégrateur (28,30,27) de ladite première erreur de phase et de ladite erreur de fréquence pour générer une tension d'erreur (VC) fonction de ladite erreur de phase et de ladite erreur de fréquence, et circuit dans lequel
- lesdits troisièmes moyens (6) comportent un premier commutateur analogique (33) et un diviseur de tension (34,35) relié à la sortie dudit premier commutateur (33),
- lesdits seconds moyens comportent ledit comparateur de fréquence (20), ledit réseau intégrateur (28,30,27) et une second commutateur analogique (31) pour découpler ledit premier signal d'erreur de phase d'avec l'entrée dudit réseau intégrateur,
- lesdits quatrièmes moyens comportent un premier amplificateur opérationnel (37) qui effectue, avec gain, l'opération consistant à soustraire d'une tension de référence la tension générée par lesdits troisièmes moyens, et
- lesdits cinquièmes moyens comportent un troisième commutateur analogique (42) relié à la sortie dudit premier amplificateur opérationnel (37) et un condensateur (41) relié entre la sortie dudit troisième commutateur et la masse.
